Europäisches Patentamt

European Patent Office

Office européen des brevets

(11) Publication number: **0 136 672**
**B1**

(12) **EUROPEAN PATENT SPECIFICATION**

(45) Date of publication of patent specification: **19.12.90**

(21) Application number: **84111626.2**

(22) Date of filing: **28.09.84**

(51) Int. Cl.⁵: **G 03 F 7/20, G 03 F 1/00**

(54) Method and apparatus for X-ray exposure.

(30) Priority: **30.09.83 JP 180684/83**

(43) Date of publication of application:
**10.04.85 Bulletin 85/15**

(45) Publication of the grant of the patent:
**19.12.90 Bulletin 90/51**

(84) Designated Contracting States:
**DE FR GB**

(56) References cited:

**PATENTS ABSTRACTS OF JAPAN, vol. 5, no.
179 (E-82)851r, 17th November 1981; & JP-A-56
104 438**

(73) Proprietor: **HITACHI, LTD.**
**6, Kanda Surugadai 4-chome**
**Chiyoda-ku, Tokyo 100 (JP)**

(72) Inventor: **Kembo, Yukio**
**619-2-272, Nobamachi Konan-ku**
**Yokohama (JP)**
Inventor: **Kuni, Asahiro**
**20-6, Nakamachi-4-chome Setagaya-ku**
**Tokyo (JP)**

(74) Representative: **Altenburg, Udo, Dipl.-Phys.
et al
Patent- und Rechtsanwälte Bardehle-
Pagenberg-Dost-Altenburg & Partner Postfach
86 06 20
D-8000 München 86 (DE)**

Courier Press, Leamington Spa, England.

## Description

The present invention relates to a method and an apparatus for X-ray exposure to transfer a pattern shape formed on a mask onto a photoresist layer applied to the surface of a wafer.

Such as integrated circuits (IC) or large scale integrated circuits (LSI) are so manufactured in order to obtain desired circuits as by forming a photoresist layer covering the surface of a wafer made of silicon, transferring a desired pattern formed on a mask onto the photoresist layer, and performing repetitive processing such as etching, ion-implantation or the like in accordance with the transferred pattern.

In order to attain a more improved integration density for the LSIs or the like, it is necessary to form a miniaturized pattern in which the width of an electric passage constituting electrical circuits is 1 µm or a more narrower sub-micron. In order to meet with such requirements, it has been suggested to employ X-rays which have shorter wavelength than conventionally utilized light rays and have a good precision of transferring.

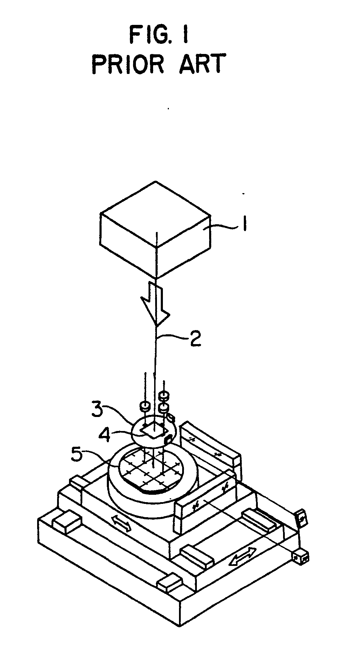

Fig. 1 shows an outline of a prior art of step-and-repeat type X-ray exposure apparatus. X-rays 2 from an X-ray source 1 are irradiated on a mask 3, and a pattern 4 on the mask 3 is transferred onto a photoresist on a wafer 5. In a precise transferring with a sub-micron electric passage width, an exposure onto the surface of the wafer 5 is successively carried out by step-and-repeat in which by an exposure area at one time is taken in a small area. One of the reasons for this is to improve the precision of dimension.

A short wavelength X-ray (called as a hard X-ray) for medical care is not used for the X-ray source 1, but a low permeability and long wavelength X-ray (called as a soft X-ray) is used for the X-ray source 1 for some reasons associated with the material of the mask described later. More specifically, such as $M_o$—$L_\alpha$ rays 5.4 Å or the like, having a wavelength of several Å to several tens Å, are used. Soft X-rays are selectively used among white X-rays, such as obtained from the SOR (Synchrotron Orbital Radiation).

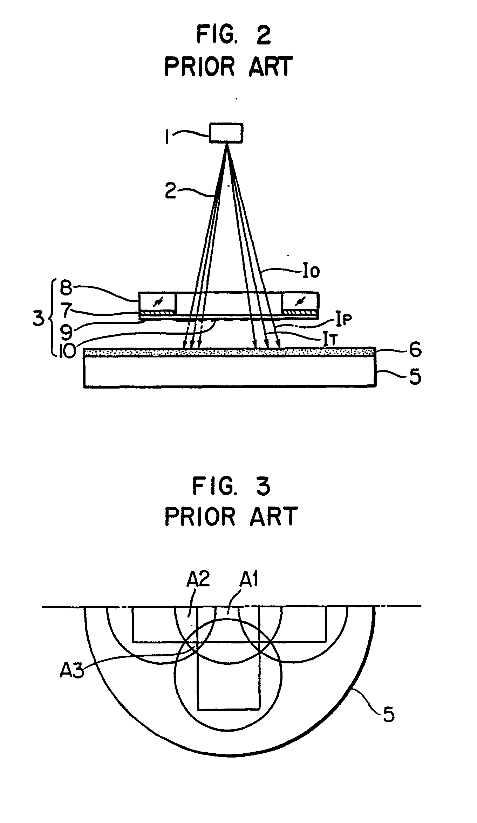

Next, the problems associated with the prior art step-and-repeat type X-ray exposure apparatus will be described with reference to Figs. 2 and 3. The mask 3 comprises a supporting ring 7 (for example, made of silicon), a back ring 8 for reinforcing the supporting ring (for example, made of a plate glass), a membrane 9 (for example, made of organic material or inorganic material such as BN, $Si_3N_4$ or the like) applied to and extended along the supporting ring 7 for serving as an X-ray permeable member, and a pattern section 10 (such as having 0.8 µm thickness of gold) for patterning by intercepting the X-rays.

One of the important factors to be considered in transferring of a pattern onto the photoresist layer 6 with X-rays, is a contrast C of the pattern 10 at the wavelength of the X-rays from the X-ray source 1 exposing the photoresist 6. Although it is better the larger the contrast C is, the X-ray exposure is hard to obtain a larger contrast regardless of an appropriate selection of the wavelength, due to the fact that X-rays are stronger in transmission than visual light rays. An X-ray transmission coefficient K of an object irradiated by X-rays is expressed in the following formula.

$$K = e^{-\mu t} \qquad (1)$$

where µ: absorption factor
t: thickness

The following relation can be established assuming that the X-ray intensity before the transmission into the mask is $I_o$, the intensity after the transmission from the pattern is $I_p$, and the intensity after the transmission from the transmission section is $I_t$.

$$I_p = K_p \cdot I_o \qquad (2)$$

$$I_t = K_t \cdot I_o \qquad (3)$$

$K_p$: a transmission coefficient of the pattern section, $K_t$: an X-ray transmission coefficient of the transmission section.

Representing a contrast of the exposure at a time (called as a shot) by $C_1$, then

$$C_1 = \frac{I_t}{I_p} \qquad (4)$$

Since the step-and-repeat system carries out a number of shots, the exposure conditions on each portion of the surface of the wafer, however, can not be maintained uniform as illustrated in Fig. 3. In Fig. 3, small circle and semi-circles on the wafer 5 indicate each shot. That is, for example, the area A1 is exposed one time and its contrast is $C_1$. However, in the areas A2 and A3, two times and three times multiple exposures are respectively brought about. More in particular, for example, the area A2 is not exposed with a pattern of an adjacent exposure area, but is irradiated with X-rays transmitted through a thin gold layer of an adjacent exposure area so that the contrast is worsened. As a result, the contrasts $C_2$ and $C_3$ for the areas A2 and A3 respectively are:

$$C_2 = \frac{I_t + I_p}{2I_p} \qquad (5)$$

$$C_3 = \frac{I_t + 2I_p}{3I_p} \qquad (6)$$

In general, the contrasting $C_N$ for the N-multiple exposure is represented by:

$$C_N = \frac{I_t + (N-1)\,2I_p}{N \times I_p} \qquad (7)$$

Therefore, even if the contrast $C_1$ in the formula (4) is, for example, 10, the contrasts $C_2$ and $C_3$ are largely deteriorated 5.5 and 4 respectively. Therefore, in the case all the areas A1, A2, and A3 are exposed, material should be chosen in correspondence with the area A3 having the smallest contrast. In order to follow the above, the thickness of gold of the pattern section 10 is required to have for example 1 μm. Assuming that the width of a wiring line is 0.5 μm, it is necessary to realize a pattern with an aspect ratio of 2, which is extraordinary hard to manufacture. Further, the difference of contrasts among the areas A1, A2, and A3 becomes large so that the controllability for the width of transferred pattern becomes worse, which results in a great hardness for the control of a wiring line width such as 0.5 μm ± 0.1 μm.

As described above, in the conventional step-and-repeat type X-ray exposure system, there occurs such problems as the deterioration of contrast on multiple exposure portions, and the worsening of the control of an electric passage width resulting from the lack of uniformity of contrasts. Thus, the applications utilizing X-rays have been suppressed.

Document "Patent Abstracts of Japan, Vol. 5, no. 179 (E—82) (851), 17th November 1981" describes a X-ray lithographic device comprising an X-ray window and a X-ray shielding plate in close proximity to the X-ray source.

The present invention has been made in view of the above circumstances, and it is an object to provide a method for X-ray exposure and an exposure apparatus suitable for practicing the method as above, in which the X-ray exposure for the area other than the required area is intercepted for every shot so that there is no fear of making the contrasts of adjacent areas worsen.

A further object is to provide an improved apparatus for X-ray exposure which is adaptive to changing of a mask pattern or shot area, while contrast characteristic is improved.

These objects are solved by the method for X-ray exposure according to claim 1 and by the apparatus for X-ray exposure according to claim 2, respectively.

The present invention will be apparent from the following detailed description taken in conjunction with the accompanying drawings, in which:

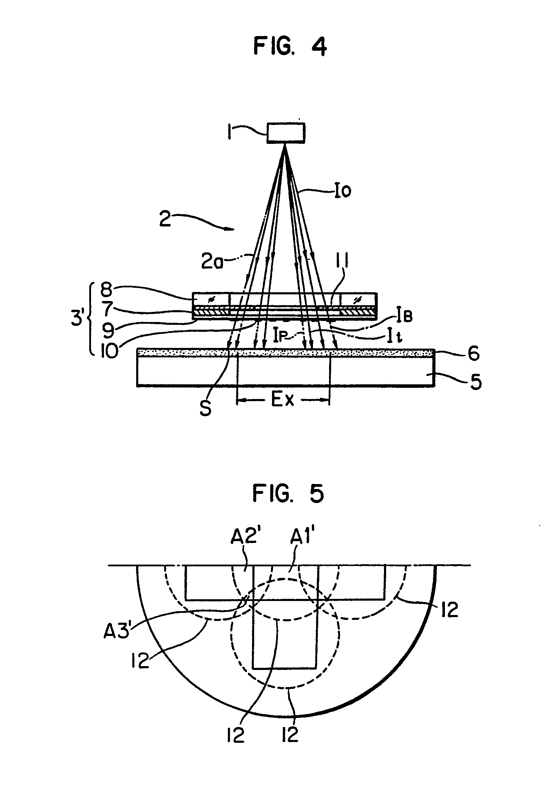

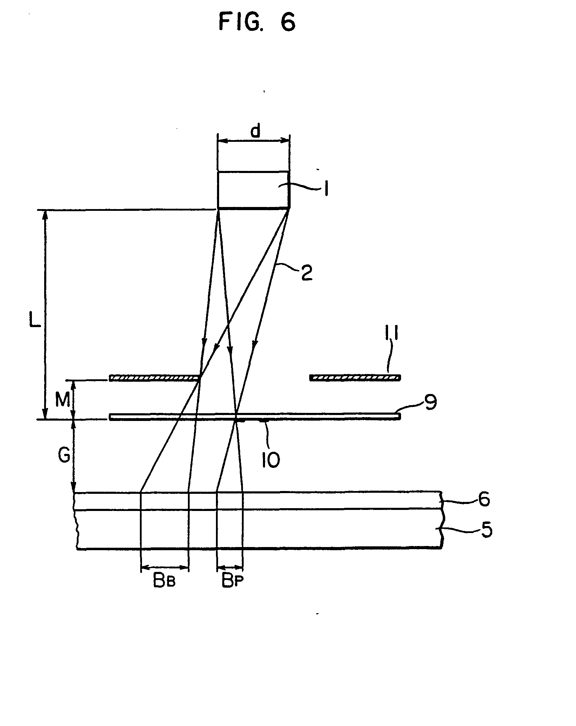

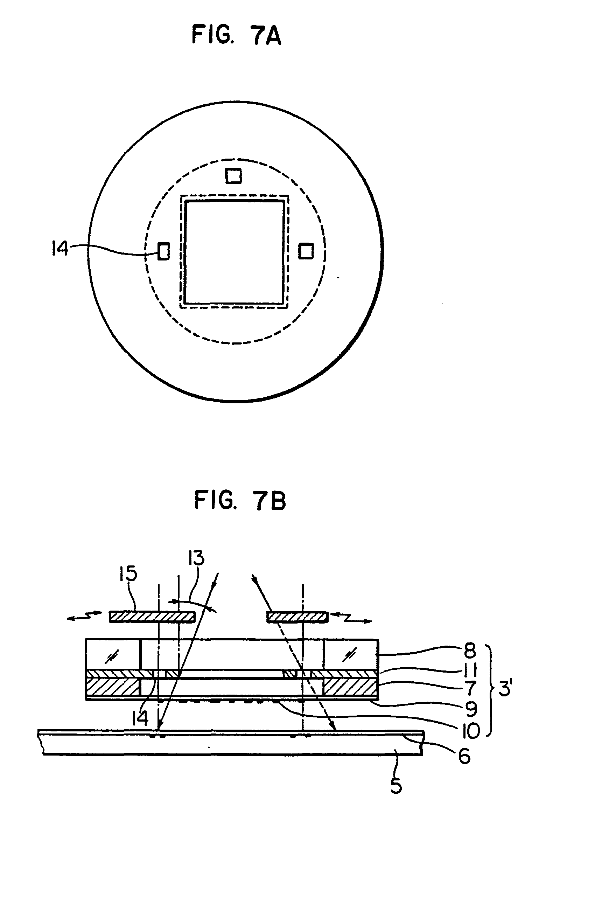

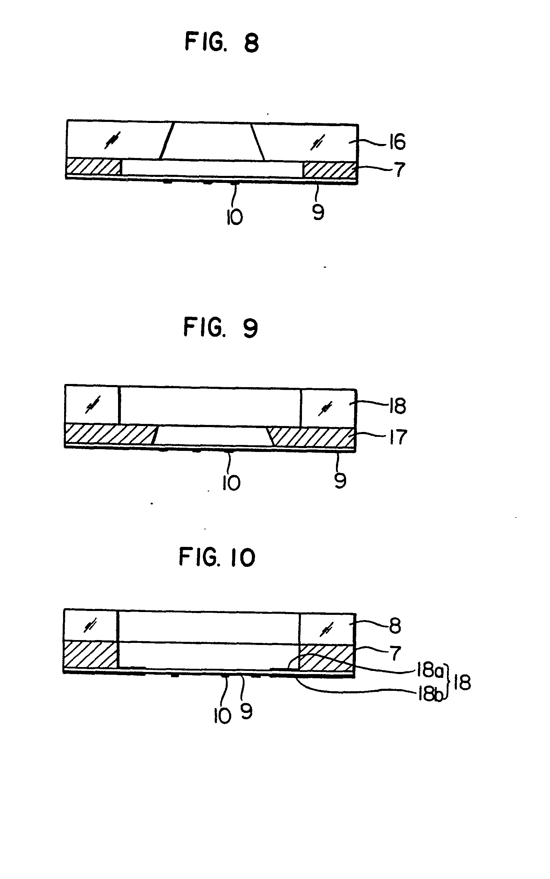

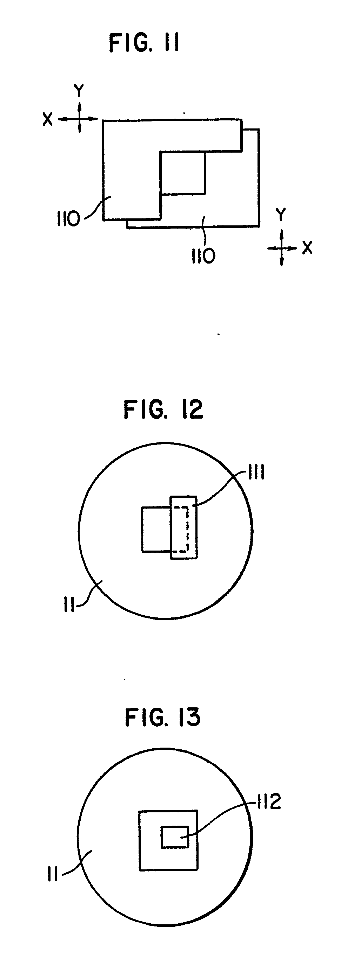

Fig. 1 is a perspective view simplified X-ray exposure apparatus for explaining the X-ray exposure, Fig. 2 is a vertical sectional view of a prior art X-ray exposure to apparatus, Fig. 3 is a plan view showing the top surface of a wafer in the X-ray exposure apparatus of Fig. 2, Fig. 4 is a vertical section showing one embodiment according to the present invention, Fig. 5 is a plan view showing the top surface of a wafer in the above embodiment of Fig. 4, Fig. 6 is a diagram for explaining the position precision in the above embodiment of Fig. 4, Figs. 7 are concrete arrangements of masks in the above embodiment of Fig. 4, wherein Fig. 7A is a plan view and Fig. 7B is a vertical section. Figs. 8 through 10 are vertical sections of masks different from the above embodiment, Fig. 11 is a plan view showing a top surface of a stop according to further embodiment of the invention, Fig. 12, is a plan view showing a top surface of a stop according to further embodiment of the invention, and Fig. 13 is a partial plan view of the stop according to the other embodiment of the invention.

One of the embodiments according to the present invention will now be described with reference to Figs. 4 to 7.

Fig. 4 is a diagram conceptually showing a stop means for intercepting surplus X-rays in accordance with the present invention, and Fig. 5 is a view for illustrating the operation of the stop means. By X-rays 2 from an X-ray source 1, a pattern section 10 on a mask 3' is transferred onto a photoresist 6 on a wafer 5. The radiation area of the X-rays 2 reaching the mask 3' is restricted by a stop 11 on the mask 3' such that as shown in Fig. 5 each shot 12 is not subject to a multiple exposure even under the exposure method of a step-and-repeat system. The stop 11 according to the present invention is not for limiting the amount of rays passing through the stop, but is for restricting the exposure area for the X-rays passing through the stop.

That is, in Fig. 4, assuming the condition where the stop 11 is temporarily removed, the X-ray on an optical path shown by an imaginary arrow line 2a among the X-rays 2 reaches a point S outside an exposure area Ex through it is weakened by a thin golf film of the pattern section 10. Therefore, the contrasts of the portions adjacent to the exposure area Ex are worsened.

However, with the stop 11 provided as shown in Fig. 4, the X-rays reaching outside of the exposure area Ex are fully intercepted so that the contrasts for the adjacent areas are not deteriorated.

In order to attain the above effects, the stop 11 is made of a material not allowing the transmission of X-rays (more in detail, by using a material with a low transmission coefficient for X-rays, having such a thickness that makes it possible to consider the transmission amount of X-rays as substantially zero in a practical use), and is constructed to have a configuration (described later in detail) covering the area other than the exposure area Ex.

A detailed description is further given as to the shielding effects of the above stop 11. The intensity $I_B$ of an X-ray passing the stop 11 is:

$$I_B = I_o \cdot K_B \qquad (8)$$

wherein $K_B$ is an X-ray transmission coefficient of the stop 11.

Similar to the formulas (4) to (6) explained with the prior art, the calculation of the contrasts $C_1'$, $C_2'$, and $C_3'$ for areas A1', A2', and A3' yields:

$$C_1' = \frac{I_t}{I_p} \qquad (9)$$

$$C_2' = \frac{I_t + I_B}{I_p + I_B} \qquad (10)$$

$$C_3' = \frac{I_t + 2I_B}{I_p + 2I_B} \qquad (11)$$

The contrast $C_N'$ for the area subjecting to N-multiple exposures is generally represented by:

$$C_N' = \frac{I_t + (N-1)I_B}{I_p + (N-1)I_B} \qquad (12)$$

which shows that the contrast for such an area is large when compared with that represented by the formula (7) indicative of the contrast in the prior art.

The material quality and thickness of the stop 11 are selected in compliance with the following procedure and criterion: (1) N is determined by the maximum number of mutiple exposures in the step-and-repeat process. (2) the contrast and contrast precision necessary for transferring the pattern section 10 are determined and represented as $C_p \pm \Delta Cp$. (3) the above determinations along with the formulas (12) and (9), give the following:

$$C_N' - C_1' \leqq 2\Delta Cp \qquad (13)$$

and

$$C_N' \geqq Cp - \Delta Cp \qquad (14)$$

$I_b$ is determined so as to suffice the formulas (13) and (14), then the transmission coefficient is determined from the formula (8), and the material quality and thickness are derived from the formula (1).

The material quality and thickness of the stop 11 have been determined from the preceding description. Next, the position of the stop 11 will be described with reference to Fig. 6. In an X-ray exposure, a penumbra Bp of the pattern section 10 is existed on the photoresist 6 by the X-ray source 1 with a dimension of d.

$$Bp = \frac{d}{L} \times G \qquad (15)$$

where L: a distance between the pattern section 10 and the X-ray source 1,

G: a gap between the pattern section 10 and the photoresist 6.

The stop 11 as well produces a penumbra $B_B$ as shown in the figure:

$$B_B = \frac{d}{L-M} \times (M + G) \qquad (16)$$

where M: a distance between the stop 11 and the pattern section.

The penumbra B is a distance between the adjacent shots 12 (refer to Fig. 5), and it is commonly a scribe area (about 50 to 100 µm). If an allowance value for the penumbra $B_B$, a penumbra Bp, an X-ray source diameter d, and gap G are determined, then, by using the formulas (15) and (16), the distance of the stop 11 from the pattern section 10 is determined. Further, the precision for determining the position of the stop 11 in horizontal direction with respect to the mask surface may be determined by the space between adjacent shots in consideration of the penumbra $B_B$, such that the tolerances of the stop position and penumbra $B_B$ are included within the space of shots.

A concrete plan view of the mask 3' in the above embodiment is shown in Fig. 7A, and the similar front section is shown in Fig. 7B. A stop 11 made of aluminum plate of 1 mm$^t$ is bonded between the supporting ring 7 and the back ring 8. The inner edge surface cut out of the aluminum plate are machined in accordance with the radiation angle 13 of the X-ray 2. In addition, flatness of the machined inner edge surface of stop 11 is finished within about $\pm 1$ µm. Moreover, an alignment aperture 14 is provided for enabling an alignment. In the case when the alignment pattern is not transferred, a shutter 15 may be mounted at the side of the X-ray source. The construction and position of the shutter 15 are determined similarly to the stop 11. The shutter 15 is of such an arrangement that when the alignment is carried out it is opened and when the exposure is carried out it is closed. The working for the edge surface of the stop 11 made of aluminum can be dispensed with sometimes depending upon the precision for determining the position of the penumbra $B_B$ or the like.

Fig. 8 shows another embodiment different from the one described above. In this embodiment, a back ring 16 is provided which has both functions of the supporting ring and the back ring.

Fig. 9 shows a further different embodiment in which a stop supporting ring 17 is provided which has both functions of the supporting ring and the stop.

Fig. 10 shows a still further different embodiment. In this embodiment, attached to a membrane 9 is a stop 18 which comprises an upper stop 18a provided for the adjustment of a tension force of the membrane and a lower stop 18b provided at the lower side of the membrane 9.

In the embodiment just described above, either one of the upper and lower stops 18a and 18b may be omitted. Also, it may be possible to additionally employ each stop means respectively described in the above embodiments.

The other embodiments will be explained with referring to Figs. 11 to 13 below.

Fig. 11 shows only a stop apparatus which is formed by two separated movable plates 110. The movable plates 110 can be slided in the horizontal direction of arrows X and Y manually or by a driving device, so that the opening shape or area can be varied at one's desire. Therefore in this embodiment, the X-ray exposure apparatus can adaptive to various shapes of the patterns without deteriorating contrast characteristic, and can also expose only a particular portion of wafer.

In further embodiment of Fig. 12, the opening of the stop 11 is fixed. However, another plate 111 which is un-permeable to X-ray covers the opening. The shape and area of the opening can be controlled by sliding the plate 111 so as to obtain same effects as shown in the embodiment of Fig. 11.

In the other embodiment of Fig. 13, the opening is covered by a layer of which material is permeable to X-ray. Another plate 112 which is nonpermeable to X-ray is disposed on the opening layer. Therefore, X-ray can be passed only an area than the plate 112 in the opening of the stop 11. An area of the exposing shot can be controlled according to the shape and position of the plate 112.

In addition to above embodiments, stop 11 can be rotated in a horizontal plane so as to change shot area of the wafer.

As seen from the above detailed description of a method for X-ray exposure according to the present invention, excellent practical effects can be obtained wherein the X-ray exposure for the area other than the required area is intercepted for every shot so that there is no fear of making the contrasts of adjacents areas worsen.

Further, according to the X-ray exposure apparatus of the present invention, it is possible to practice the above method with ease and to sufficiently manifest the effects thereof.

## Claims

1. Method for X-ray exposure by step-and-repeat in which the X-rays radiated from an X-ray source (1) are transmitted through an X-ray exposure subjecting mask (3') and irradiated upon an X-ray exposure subjecting substrate (5), and in which a pattern (10) shape provided on said mask is transferred onto said substrate, said method for exposing X-rays comprising positioning a stop (11) being part of the mask itself between said X-ray source and said substrate, said stop being separated from said exposure subjecting pattern of the mask, and intercepting the incident X-rays to the portion other than the exposure portion (Ex) on said substrate surface.

2. Apparatus for carrying out the method according to claim 1, comprising: a X-ray source (1); a X-ray exposure subjecting mask (3'); means for fixing and moving said source, mask and an X-ray exposure subjecting substrate (5) in a step-and-repeat manner, respectively, said X-rays radiated from said X-ray source being passed through said X-ray exposure subjecting mask and irradiated upon said X-ray exposure subjecting substrate so as to transfer a pattern shape on said mask onto said substrate; and X-ray stop means (11) being part of the mask itself provided between said X-ray source and said substrate, said stop means being separated from said pattern of the mask.

3. An apparatus for X-ray exposure according to claim 2, in which said stop means is so constructed as to intercept the X-rays passing through a portion other than said pattern provided on said mask for transferring said pattern shape.

4. An apparatus for X-ray exposure according to claim 3, in which said stop means is provided on an area of said mask other than another area on which said pattern for transferring is positioned, and in which said stop means is fixed to said mask.

5. An apparatus for X-ray exposure according to claim 2, in which said stop means has both functions of a back ring and a stop.

6. An apparatus for X-ray exposure according to claim 2, in which said stop means has both functions of a supporting ring and a stop.

7. An apparatus for X-ray exposure according to claim 2, in which said stop means is formed by attaching a stop to a membrane.

## Patentansprüche

1. Verfahren zur Belichtung mit Röntgenstrahlen, schrittweise und durch Wiederholung, bei dem die von einer Röntgenstrahlquelle abgestrahlten Röntgenstrahlen durch eine einer Röntgenstrahlbelichtung ausgesetzten Maske (3') übertragen werden und auf ein einer Röntgenstrahlbelichtung ausgesetztes Substrat (5) gestrahl werden, und bei dem eine Musterform (10), die auf der Maske vorgesehen ist, auf das Substrat übertragen wird, wobei das Verfahren zum Belichten mit Röntgenstrahlen eine Einstellung einer Blende (11) zwischen der Röntgenstrahlquelle und dem Substrat aufweist, die Teil der Maske selbst ist, wobei die Blende getrennt von dem der Belichtung ausgesetzten Muster der Maske ist und ein Auffangen der einfallenden Röntgenstrahlen auf den anderen Teil als den Belichtungsteil (Ex) auf der Substratoberfläche.

2. Gerät zum Ausführen des Verfahrens nach Anspruch 1, das aufweist:

eine Röntgenstrahlquelle (1); eine einer Röntgenstrahlbelichtung ausgesetzte Maske (3'); eine Einrichtung zum Feststellen und zum Bewegen jeweils der Quelle, der Maske und ein einer Röntgenstrahlbelichtung ausgesetztes Substrat (5), schrittweise und durch Wiederholung, wobei die von der Röntgenstrahlquelle abgestrahlten Röntgenstrahlen durch die einer Röntgenstrahlbelichtung ausgesetzten Maske hindurchgeführt werden und auf das einer Röntgenstrahlbelichtung ausgesetzte Substrat abgestrahlt werden, um eine Musterform auf der Maske auf das Substrat zu übertragen; und eine Röntgenstrahl-Blendeneinrichtung (11), die Teil der Maske selbst zist und zwischen der Röntgenstrahlquelle und dem Substrat vorgesehen ist, wobei die Blendeneinrichtung von dem Muster der Maske getrennt ist.

et l'interception des rayons X incidents sur la partie autre que la partie d'exposition (Ex) située sur ladite surface du substrat.

2. Dispositif pour la mise en oeuvre du procédé selon la revendication 1, comprenant: une source (1) de rayons X; un masque (3') d'exposition aux rayons X; des moyens pour fixer et déplacer, selon un mode pas à pas, respectivement ladite source, ledit masque et ledit substrat (5) d'exposition aux rayons X, lesdits rayons X émis par ladite source de rayons X traversant ledit masque d'exposition aux rayons X et irradiant ledit substrat d'exposition aux rayons X de manière à transférer une forme de structure située sur ledit masque sur ledit substrat; et des moyens (11) formant diaphragme des rayons X, faisant partie du masque lui-même et prévus entre ladite source de rayons X et ledit substrat, lesdits moyens formant diaphragme étant séparés de ladite structure du masque.

3. Dispositif d'exposition aux rayons X selon la revendication 2, dans lequel lesdits moyens formant diaphragme sont agencés de manière à intercepter les rayons X traversant une partie autre que ladite structure prévue sur ledit masque pour le transfert de ladite forme de structure.

4. Dispositif d'exposition aux rayons X selon la revendication 3, dans lequel lesdits moyens formant diaphragme sont prévus sur une surface dudit masque, autre que ladite autre surface sur laquelle est positionnée ladite structure utilisée pour le transfert, et dans lequel lesdits moyens formant diaphragme sont fixés audit masque.

5. Dispositif d'exposition aux rayons X selon la revendication 2, dans lequel lesdits moyens formant diaphragme possèdent à la fois les fonctions d'un anneau arrière et d'un diaphragme.

6. Dispositif d'exposition aux rayons X selon la revendication 2, dans lequel lesdits moyens formant diaphragme possèdent à la fois les fonctions d'un anneau de support et d'un diaphragme.

7. Dispositif d'exposition aux rayons X selon la revendication 2, dans lequel lesdits moyens d'arrêt sont formés par fixation d'un diaphragme à une membrane.

# FIG. I
## PRIOR ART

## FIG. 2
## PRIOR ART

## FIG. 3
## PRIOR ART

# FIG. 4

# FIG. 5

# FIG. 6

## FIG. 7A

## FIG. 7B

## FIG. 8

## FIG. 9

## FIG. 10

## FIG. 11

## FIG. 12

## FIG. 13